# EUROPEAN PATENT SPECIFICATION

(11) **EP 2 412 746 B1**
(45) Date of publication and mention of the grant of the patent: **03.07.2013**
(21) Application number: 11175706.8
(22) Date of filing: 28.07.2011
(51) Int. Cl.: C08G 77/12, C08G 77/20, C08G 77/50, C08L 83/04, H01L 31/0203, H01L 31/0216, H01L 51/52, H01L 31/048

(54) **Modified siloxane polymer composition, encapsulant obtained from the modified siloxane polymer composition and electronic device including the encapsulant**
Modifizierte Siloxanpolymerzusammensetzung, mit der modifizierten Siloxanpolymerzusammensetzung hergestellter Verkapselungsstoff und elektronische Vorrichtung mit dem Verkapselungsstoff
Composition de polymère de siloxane modifié, agent d'encapsulation obtenu par la composition de polymère de siloxane modifié et dispositif électronique incluant l'agent d'encapsulation

(30) Priority: 29.07.2010 KR 20100073511
(43) Date of publication of application: 01.02.2012
(73) Proprietor: Cheil Industries Inc., Kumi-city, Kyungsangbuk-do 730-030 (KR)
(72) Inventor: Kim, Woo-Han, Uiwang-si, Gyeonggi-do (KR); Shin, June-Ho, Uiwang-si, Gyeonggi-do (KR); Koh, Sang-Ran, Uiwang-si, Gyeonggi-do (KR); Cha, Sung-Hwan, Uiwang-si, Gyeonggi-do (KR); Ahn, Hyun-Jung, Uiwang-si, Gyeonggi-do (KR)
(74) Representative: Michalski Hüttermann & Partner Patentanwälte

(56) References cited:
- WO-A1-03/093369
- US-A1- 2006 106 187
- US-A1- 2006 134 440
- US-A1- 2006 275 617
- US-A1- 2009 281 243

## Description

### BACKGROUND

### 1. Field

Embodiments relate to a modified siloxane polymer composition, an encapsulant obtained from the modified siloxane polymer composition, and an electronic device including the encapsulant.

### 2. Description of the Related Art

A light emitting element such as a light emitting diode (LED), an organic light emitting device (OLED), a photoluminescent (PL) device, and the like has been variously applied to a domestic electric device, a lighting device, a display device, various automatic devices, and the like. The light emitting element may display intrinsic colors of a light emitting material, such as blue, red, and green, using a light emitter, or display white by combining light emitters displaying different colors. The light emitting element may generally have a packaging or encapsulation structure. This packaging or encapsulation structure may be made of an encapsulant including a transparent resin that is able to externally transmit light emitted from the light emitting element. This encapsulant may be located where light passes or is transmitted. Accordingly, it may be desirable for the encapsulant to exhibit heat and light resistance.

Siloxane polymers are disclosed in the US 2006/106187, US 2006/275617 and US 2009/28143.

### SUMMARY

Embodiments are directed to a modified siloxane polymer composition, an encapsulant obtained from the modified siloxane polymer composition, and an electronic device including the encapsulant.

The embodiments may be realized by providing a modified siloxane polymer composition including a modified siloxane polymer and a reticular siloxane polymer, the modified siloxane polymer including a cyclic siloxane moiety having at least two Si-O bonds with a cyclic structure, a substituted or unsubstituted linear siloxane moiety linked to Si of the cyclic siloxane moiety with a C2 to C10 alkylene group therebetween, and double bonds at its terminal ends.

The modified siloxane polymer may be obtained by a reaction of a compound represented by the following Chemical Formula 1 and a compound represented by the following Chemical Formula 2: 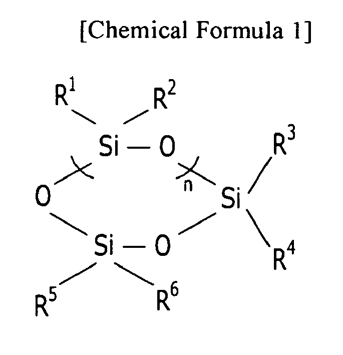 In the Chemical Formula 1, R¹ to R⁶ are each independently a hydrogen atom, a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, halogen, or a combination thereof, at least two of R¹ to R⁶ are hydrogen, and n is an integer of 0 to about 10. 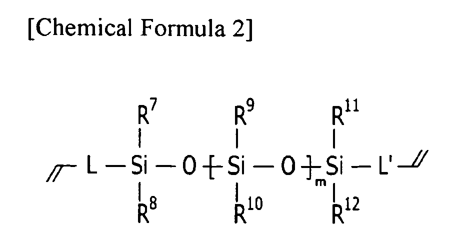 In the Chemical Formula 2, L and L' are each independently a single bond, a C1 to C8 alkylene group, R⁷ to R¹² are each independently a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, halogen, or a combination thereof, and m is an integer of 0 to about 500.

The L and L' of the compound represented by Chemical Formula 2 may be each independently selected from a single bond, a methylene group, an ethylene group, a propylene group, a butylene group, and a pentylene group.

The cyclic siloxane moiety may be included at an average of one or more per a molecule of the modified siloxane polymer.

The modified siloxane polymer may have a number average molecular weight of about ≥500 Da to ≤30000 Da, more preferred ≥1000 Da to ≤25000 Da and most preferred ≥2000 Da to ≤15000 Da.

The modified siloxane polymer may be included in an amount of amount of ≥ 5 to ≤ 95 wt%, more preferred ≥ 10 to ≤ 90 wt% and most preferred ≥ 20 to ≤ 80 wt%.

The reticular siloxane polymer may be represented by the following Chemical Formula 3:

[Chemical Formula 3] [R¹³SiO_{3/2}]_{T}[R¹⁴R¹⁵SiO]_{D}[R¹⁶R¹⁷R¹⁸SiO_{1/2}]_{M}

wherein in Chemical Formula 3, R¹³ to R¹⁸ are each independently a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, a halogen, or a combination thereof, provided that at least one of R¹⁰, R¹¹ and R¹² is an alkenyl group, T>0, D≥0, M>0, and T+D+M=1.

The modified siloxane polymer composition may further include a curing agent including at least two silicon-hydrogen bonds.

The modified siloxane polymer composition may further include a hydrosilylation reaction catalyst.

The embodiments may also be realized by providing an encapsulant obtained by curing the modified siloxane polymer composition of an embodiment.

The embodiments may also be realized by providing an electronic device including the encapsulant of an embodiment.

### DETAILED DESCRIPTION

Example embodiments will now be described more fully hereinafter; however, they may be embodied in different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

As used herein, when a definition is not otherwise provided, the term "substituted" refers to one substituted with at least a substituent selected from the group consisting of a halogen (F, Br, Cl, or I), a hydroxy group, an alkoxy group, a nitro group, a cyano group, an amino group, an azido group, an amidino group, a hydrazino group, a hydrazono group, a carbonyl group, a carbamyl group, a thiol group, an ester group, a carboxyl group or a salt thereof, a sulfonic acid group or a salt thereof, a phosphoric acid group or a salt thereof, alkyl group, a C2 to C16 alkenyl group, a C2 to C16 alkynyl group, C6 to C30 aryl group, a C7 to C13 arylalkyl group, a C1 to C4 oxyalkyl group, a C1 to C20 heteroalkyl group, a C3 to C20 heteroarylalkyl group, a C3 to C30 cycloalkyl group, a C3 to C15 cycloalkenyl group, a C6 to C15 cycloalkynyl group, a heterocycloalkyl group, and a combination thereof, instead of hydrogen of a compound.

As used herein, when a definition is not otherwise provided, the term "hetero" refers to one, e.g., a ring, including 1 to 3 heteroatoms selected from N, O, S, and P.

Hereinafter, a modified siloxane polymer composition according to an embodiment is described. The modified siloxane polymer composition according to the present embodiment may include a modified siloxane polymer and a reticular siloxane polymer.

The modified siloxane polymer may include a cyclic siloxane moiety having at least two Si-O bonds with a cyclic structure, a substituted or unsubstituted linear siloxane moiety linked to Si of the cyclic siloxane moiety with a C2 to C10 alkylene group therebetween, and double bonds at its terminal ends.

The modified siloxane polymer may be obtained by a reaction of a compound represented by the following Chemical Formula 1 and a compound represented by the following Chemical Formula 2:

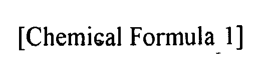

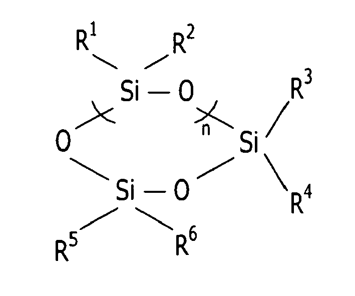

In the Chemical Formula 1, R¹ to R⁶ are each independently a hydrogen atom, a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, halogen, or a combination thereof, at least two of R¹ to R⁶ are hydrogen, and n is an integer of 0 to about 10.

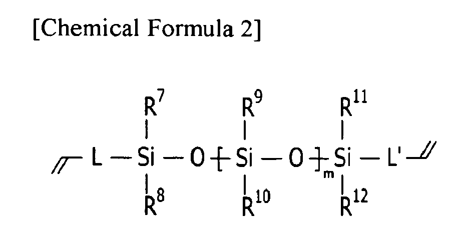

In the Chemical Formula 2, L and L' are each independently a single bond, a C1 to C8 alkylene group, R⁷ to R¹² are each independently a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, halogen, or a combination thereof, and m is an integer of 0 to about 500.

In an implementation, the L and L' of the compound represented by the Chemical Formula 2 may include a single bond, C1 to C5 alkylene group, e.g., single bond, a methylene group, an ethylene group, a propylene group, a butylene group, and/or a pentylene group.

The compound represented by Chemical Formula 1 may be a cyclic siloxane compound in which silicon (Si) and oxygen (O) are linked to form a cyclic structure. In an implementation, in the Chemical Formula 1, when n=0, *-Si-O-Si-O-* forms a tetracyclic structure, and when n=1, *-Si-O-Si-O-Si-O-* forms a hexacyclic structure, and so on.

The cyclic siloxane moiety in the structure of the modified siloxane polymer may be formed from the cyclic siloxane compound, and the cyclic siloxane moiety may be included at an average of one or more per molecule of the modified siloxane polymer. By these structures, the modified siloxane polymer composition may have a low coefficient of thermal expansion (CTE) and low modulus, thereby resulting in improvement of crack-resistance.

The compound represented by Chemical Formula 2 may be a linear siloxane compound in which silicon (Si) and oxygen (O) are linked to form a linear structure. The linear siloxane moiety in the structure of the modified siloxane polymer may be formed from the linear siloxane compound.

In reaction of the cyclic siloxane compound and the linear siloxane compound, the hydrogen linked to silicon in the compound represented by the Chemical Formula 1 and the C-C double bond at the end of the compound represented by the Chemical Formula 2 may be reacted to be formed a bond between silicon in the compound represented by the Chemical Formula 1 and L or L' in the compound represented by the Chemical Formula 2. Herein, the C-C double bond at the end of the compound represented by the Chemical Formula 2 may be changed into an ethylene group by the reaction, thus the cyclic siloxane moiety and the linear siloxane moiety are linked by a C2 to C10 alkylene group, which has a number of carbons more than the number of carbons in L or L' of Chemical Formula 2.

The modified siloxane polymer may include carbon-carbon double bonds at terminal ends thereof. The carbon-carbon double bonds may be capable of undergoing a reaction at the terminal ends of the modified siloxane polymer. In an implementation, as represented by the following Chemical Formula a, it is preferable that one carbon forming the carbon-carbon double bond be directly linked or bonded to a silicon atom.

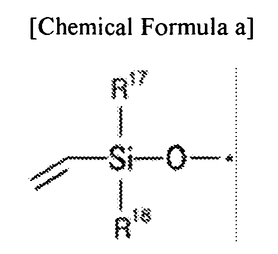

In Chemical Formula a, R¹⁷ and R¹⁸ may each independently be a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, a halogen, or a combination thereof.

The modified siloxane polymer having carbon-carbon double bonds at the terminal ends thereof may undergo a hydrosilylation reaction at a level or rate equivalent to that of the reticular siloxane polymer, which will be described below.

If the modified siloxane polymer undergoes the hydrosilylation reaction at a much lower rate compared with the reticular siloxane polymer, the reticular siloxane polymer may be cured first, thereby forming a region with a low coefficient of thermal expansion and high modulus. Then, the modified siloxane polymer may be cured, thereby resulting in poor crack resistance and poor interface adherence of a final product. However, according to an embodiment, the modified siloxane polymer may undergo the hydrosilylation reaction at a similar or equivalent rate to that of the reticular siloxane polymer, thereby ensuring good crack resistance.

The modified siloxane polymer may have a number average molecular weight of ≥500 Da to ≤30000 Da, more preferred ≥1000 Da to ≤25000 Da and most preferred ≥2000 Da to ≤15000 Da.

The modified siloxane polymer may be included in an amount of ≥ 5 to ≤ 95 wt%, more preferred ≥ 10 to ≤ 90 wt% and most preferred ≥ 20 to ≤ 80 wt%, based on a total weight of the modified siloxane polymer composition. Maintaining the amount of the modified siloxane polymer about 5 to about 95 wt% may help ensure that hardness of the modified siloxane polymer composition after the curing is maintained and that modulus within an appropriate range is maintained, thereby improving crack resistance.

In an implementation, the modified siloxane polymer may be obtained by, e.g., reacting a cyclic siloxane compound having at least two silicon-hydrogen bonds and a siloxane compound having two carbon-carbon double bonds.

For example, the modified siloxane polymer may be prepared by hydrosilylating a cyclic siloxane compound having at least two silicon-hydrogen bonds and represented by the following Chemical Formula b with a siloxane compound having two carbon-carbon double bonds and represented by the following Chemical Formula c.

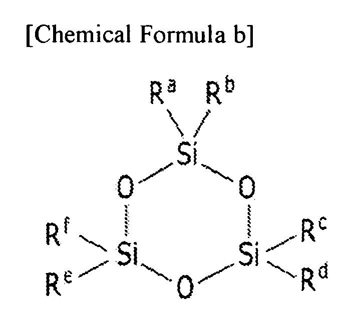

In Chemical Formula b, R^{a} to R^{f} may each independently be hydrogen, a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, a halogen, or a combination thereof. In an implementation, at least two of R^{a} to R^{f} is hydrogen.

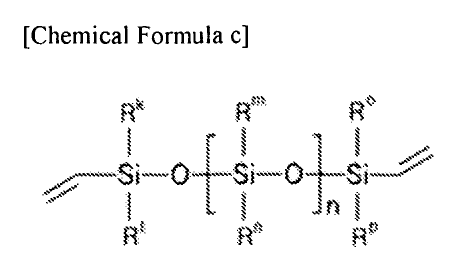

In Chemical Formulae c, R^{k} to R^{p} may each independently be a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, a halogen, or a combination thereof. In Chemical Formula c, n may be 0 to about 500.

The modified siloxane polymer may be obtained from a hydrosilylation reaction of the cyclic siloxane compound represented by Chemical Formula b with the siloxane compound represented by Chemical Formula c.

The reticular siloxane polymer may be a polymer represented by the following Chemical Formula 3.

[Chemical Formula 3] [R¹³SiO_{3/2}]_{T}[R1⁴R¹⁵SiO]_{D}[R¹⁶R¹⁷R¹⁸SiO_{1/2}]_{M}

In Chemical Formula 3, R¹³ to R¹⁸ may each independently be a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, halogen, or a combination thereof. In an implementation, at least one of R¹⁶, R¹⁷ and R¹⁸ is an alkenyl, e.g., vinyl, group. Furthermore, T, D, and M may satisfy the relations: T>0, D≥0, M>0, and T+D+M=1.

The reticular siloxane polymer may play a role of determining hardness when a hybrid siloxane polymer is cured.

The reticular siloxane polymer may be included in an amount of ≥ 1 to ≤ 95 wt%, more preferred ≥ 5 to ≤ 90 wt% and most preferred ≥ 10 to ≤ 80 wt%, based on the entire weight of the modified siloxane polymer composition. Maintaining the amount of the reticular siloxane polymer at about 1 to about 90 wt% may help ensure that hardness of the modified siloxane polymer composition after the curing is appropriately maintained.

The modified siloxane polymer composition may further include a curing agent. The curing agent may include a compound including silicon-hydrogen bonds at terminal ends thereof.

The silicon-hydrogen bond of the curing agent may be included in a ratio of about ≥ 0.5 to ≤2.0 mols, preferably ≥ 0.8 to ≤1.5 mols based on 1 mol of a double bond included in the the modified siloxane polymer and the reticular siloxane polymer. When the silicon-hydrogen bond is included within the range, a sufficient curing degree of the modified siloxane polymer composition may be achieved while simultaneously preventing oxidation or discoloring of the cured product (caused by excess non-reacted hydrogen-silicon bonds).

The curing agent may be included in an amount of about ≥5 to ≤60 wt%, based on the entire weight of the the modified siloxane polymer composition. When the curing agent is included in these amounts, hardness of the modified siloxane polymer composition after the curing may be maintained.

The modified siloxane polymer composition may further include a catalyst for hydrosilylation reaction, e.g., a hydrosilylation reaction catalyst.

The hydrosilylation reaction catalyst may be a catalyst including, e.g., platinum, rhodium, palladium, ruthenium, iridium, osmium, or a combination thereof, as a central metal. For example, the catalyst may be a Karstedt catalyst prepared through reaction of chloroplatinic acid and 1,3-divinyl-1,1,3,3-tetramethoxysiloxane.

The hydrosilylation reaction catalyst may be included in an amount of about 0.1 ppm to about 1,000 ppm, based on a total amount of the modified siloxane polymer composition.

The aforementioned modified siloxane polymer composition may be cured and thus may be used as an encapsulant for an electronic device. In an implementation, the electronic device may include, e.g., a light emitting diode, an organic light emitting device, a photo luminance device, and/or a solar cell encapsulated with a composition according to an embodiment, but is not limited thereto.

The encapsulant prepared or obtained from the modified siloxane polymer composition may exhibit heat and light resistance. The encapsulant may exhibit a decreased coefficient of thermal expansion and may also exhibit high transmittance and high refractive index, thereby improving crack resistance and adherence. In addition, generation of an oligomer having a low molecular weight during the manufacturing process of the modified siloxane polymer composition may be decreased. Thus, tackiness on a surface of the encapsulant may be decreased, thereby improving workability.

The following Examples illustrate the embodiments in more detail. However, they are exemplary embodiments of the present invention and are not limiting. Moreover, the Comparative Example is set forth to highlight certain characteristics of certain embodiments and are not to be construed as either limiting the scope of the invention as exemplified in the Examples or as necessarily always being outside the scope of the invention in every respect.

Synthesis Examples

Synthesis Example 1: Synthesis of cyclic siloxane compound

54.08 g (0.25 mol) of diphenylsilane diol was added to a four-necked flask with an agitator, a temperature controller, a nitrogen gas-injecting device, and a cooler, while flowing nitrogen therethrough, and was then dissolved in 500 g of 1,2-dimethoxyethane. 43.51 g (1.10 mol) of pyridine was added; and a temperature of reactants was decreased to 5 ° C. 115.07g (1.0 mol) of methyldichlorosilane was added dropwise thereto over 2 hours. The temperature of reactants was increased to room temperature; and agitation was performed for 24 hours. The resultant white solid was filtered; and a solvent and non-reacted methyldichlorosilane compounds were removed under a reduced pressure. Unpurified compounds were dissolved in 500 g of 1,2-dimethoxyethane and then 43.51 g of pyridine was added. The temperature of the resultant solution was decreased to 5 ° C. A solution including 54.8 g of diphenylsilane diol in 150 g of tetrahydrofuran added dropwise to the solution over 4 hours. The temperature of the resultant solution was increased to room temperature and agitation for 24 hours was preformed. A white solid precipitate was filtered and removed; and solvent was removed under a reduced pressure. While maintaining a vacuum degree at 0,026 mbar (0.02 Torr), the temperature was increased to distill 80 g of 2,2,6,6-tetraphenyl-4,8-dimethylcyclotetrasiloxane at about 150 °C.

Synthesis Example 2: Synthesis of modified siloxane polymer (1)

5.16 g of the cyclic siloxane compound obtained in Synthesis Example 1 was added to 88.5 g of a vinyl terminated polyphenylmethyl siloxane (PMV-9925 represented by the Chemical Formula 4, USA Gelest Inc.) (an amount of vinyl groups measured by 300MHz 1H-NMR was 0.45 mmol/lg) in a four-necked flask with an agitator, a temperature controller, a nitrogen gas-injecting device, and a cooler, while flowing nitrogen therethrough. Then, the temperature was increased to 90 ° C.

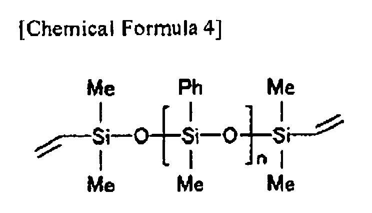

In Chemical Formula 4, Me is a methyl group, Ph is a phenyl group, and n is 42.

Then, PS-CS-1.8CS (Unicore) was added thereto, so that the reaction solution had a Pt concentration of 20 ppm. The resulting reaction solution was passed through a 5 cm-thick silica gel column to remove a platinum complex. Solvent was removed under reduced pressure distillation, thus preparing a modified siloxane polymer having a number average molecular weight of 7,000. When the modified siloxane polymer was analyzed using a gel permeation chromatography (GPC), oligomers having a low molecular weight (less than 500) were not present.

Synthesis Example 3: Synthesis of modified siloxane polymer (2)

A modified siloxane polymer was obtained according to the same method as in Synthesis Example 1 except that 7.74 g of the cyclic siloxane compound was used. As in Synthesis Example 2, when the modified siloxane polymer was analyzed using a gel permeation chromatography (GPC), oligomers having low molecular weight (less than 500) were not present.

Preparation of siloxane polymer composition

Example 1

A modified siloxane polymer composition was prepared by mixing and completely dissolving 2.56 g of the modified siloxane polymer in Synthesis Example 2, 5 g of a reticular siloxane polymer represented by the following Chemical Formula 3a, 1g of 3,3-diphenyl-1,1,5,5-tetramethyltrisiloxane and PS-CS-1.8CS (Unicore) (PS-CS-1.8CS was added so that the reaction solution had a Pt concentration of 3 ppm).

[Chemical Formula 3a] (Me₂ViSiO_{1/2})_{0.15}(PhSiO_{3/2})_{0.85}

In the modified siloxane polymer composition, a ratio of hydrogen/vinyl group (H/Vi) was 1.1:1.

Example 2

A modified siloxane polymer composition was prepared by mixing and completely dissolving 1.11 g of the modified siloxane polymer obtained in Synthesis Example 2, 5.3 g of the reticular siloxane polymer represented by Chemical Formula 3a, 1 g of 3,3-diphenyl-1,1,5,5-tetramethyltrisiloxane, and PS-CS-1.8CS (Unicore) (PS-CS-1.8CS was added so that the reaction solution had a Pt concentration of 3 ppm).

In the modified siloxane polymer composition, a ratio of hydrogen/vinyl group (H/Vi) was 1.1:1.

Example 3

A modified siloxane polymer composition was prepared by mixing and completely dissolving 3.11 g of the modified siloxane polymer obtained in Synthesis Example 3, 5 g of the reticular siloxane polymer represented by Chemical Formula 3a, 1 g of 3,3-diphenyl-1,1,5,5-tetramethyltrisiloxane, and PS-CS-1.8CS (Unicore) (PS-CS-1.8CS was added so that the reaction solution had a Pt concentration of 3 ppm).

In the modified siloxane polymer composition, a ratio of hydrogen/vinyl group (H/Vi) was 1.1:1.

Example 4

A modified siloxane polymer composition was prepared by mixing and completely dissolving 1.34 g of the modified siloxane polymer obtained in Synthesis Example 3, 5.3 g of the reticular siloxane polymer represented by Chemical Formula 3a, 1 g of 3,3-diphenyl-1,1,5,5-tetramethyltrisiloxane, and PS-CS-1.8CS (Unicore) (PS-CS-1.8CS was added so that the reaction solution had a Pt concentration of 3 ppm).

In the modified siloxane polymer composition, a ratio of hydrogen/vinyl group (H/Vi) was 1.1:1.

Comparative Example

A siloxane polymer composition was prepared by mixing and completely dissolving 1.60 g of a vinyl terminated polyphenylmethyl siloxane (PMV-9925 represented by the Chemical Formula 4) compound , 5 g of the reticular siloxane polymer represented by Chemical Formula 3a, 1 g of 3,3-diphenyl-1,1,5,5-tetramethyltrisiloxane, and PS-CS-1.8CS (Unicore) (PS-CS-1.8CS was added so that the reaction solution had a Pt concentration of 3 ppm).

In the siloxane polymer composition, a ratio of hydrogen/vinyl group (H/Vi) was 1.1:1.

Evaluation - 1

The modified siloxane polymer composition according to Examples 1 to 4 and the siloxane polymer composition according Comparative Example were heated and cured in a 150 °C oven for one hour and measured regarding initial transmittance at 450 nm. In addition, the cured resin was measured regarding how long the cured resin passed through a column using a Tack meter. The time of passing a column was criteria for measuring tackiness. The shorter a product passes through a column, the less tackiness it had.

The cured resin was allowed to stand in a 150 °C oven for 1,000 hours and again measured regarding transmittance at 450 nm. A smaller initial transmittance and transmittance difference after the heat treatment indicated excellent heat and light resistance.

The results are provided in Tables 1 to 3, below.

The coefficient of thermal expansion (CTE) was measured using a thermomechanical analysis (TMA) method. The tackiness was measured using a TOPTAC-2000A (CHEMILAB Inc.).

**Table 1**

| | Refractive index | Hardness (Shore-D) | Tackiness (gf) | Transmittance (%, 450 nm) | | |
|---|---|---|---|---|---|---|
| | | | | 0 hr | 1000 hr | ΔT |
| Ex. 1 | 1.53 | 22 | 20 | 99.3 | 91.3 | 8 |
| Ex. 2 | 1.54 | 28 | 25 | 99.7 | 92.7 | 7 |
| Ex. 3 | 1.54 | 23 | 23 | 99.9 | 90.9 | 9 |
| Ex. 4 | 1.54 | 29 | 27 | 99.5 | 90.7 | 8.8 |
| Comp. Ex. | 1.53 | 28 | 30 | 99.5 | 89.5 | 10 |

As shown in Tables 1 and 2, the modified siloxane polymer compositions according to Examples 1 to 4 exhibited similar refractive indices but low coefficients of thermal expansion, low tackiness, and a small decrease in transmittance after the heat treatment compared with the siloxane polymer composition of Comparative Example.

Evaluation - 2

The modified siloxane polymer composition according to Examples 1 to 3 and the siloxane polymer composition according to the Comparative Example were heated and cured in a 150 °C oven for one hour and measured regarding modulus values and coefficients of linear or thermal expansion of the cured products using TMA analysis.

**Table 2**

| | Modulus (kgf/mm²) | Coefficient of linear expansion α1/α2 (µm/m°C) |
|---|---|---|
| Ex. 1 | 1600 | 140/380 |
| Ex. 2 | 1400 | 120/350 |
| Ex. 3 | 1300 | 110/300 |
| Comp. Ex. | 1800 | 150/400 |

As shown in Table 2, the modified siloxane polymer composition according to Examples 1 to 3 exhibited low thermal coefficient of linear expansion and modulus values compared with the siloxane polymer composition according to Comparative Example.

Evaluation - 3

The modified siloxane polymer composition according to Examples 1 to 4 and the siloxane polymer composition according to the Comparative Example were injected into plastic cups having a 1 cm diameter and a 1 cm height, respectively, and then cured in a 150 ° C oven for 1 hour. The resultant cured resins were allowed to stand in a -30 ° C coolant bath and a 150 ° C oven, repeatedly for 30 minutes to give them thermal impact. These were repeated 20 times and then cracks of the plastic cups and cured resins were observed.

The results are provided in Table 3, in which X designates that no cracks were observed and Ⓞ designates that cracks were observed.

**Table 3**

| | Cracks |
|---|---|
| Example 1 | X |
| Example 2 | X |
| Example 3 | X |
| Example 4 | X |
| Comparative Example | ⊙ |

As shown in Table 3, the modified siloxane polymer compositions according to Examples 1 to 4 showed no cracks, whereas the siloxane polymer composition according to Comparative Example showed a large amount of cracks. These results may be attributed to the fact that the modified siloxane polymer compositions according to Examples 1 to 4 exhibited remarkably lower modulus and coefficient of thermal expansion, compared with the siloxane polymer composition according to the Comparative Example.

These results indicate that the modified siloxane polymer compositions according to Examples 1 to 4 exhibited good refractive indices, excellent heat and light-resistance, and low coefficients of thermal expansion and tackiness.

By way of summation and review, a siloxane polymer may be more desirable than an epoxy-based encapsulant, which may exhibit relatively weak heat and light resistance. However, a typical siloxane polymer may be broken or may have poor interface adherence due to a high coefficient of thermal expansion after curing. In addition, a typical siloxane copolymer encapsulant may have deteriorated workability due to high surface tackiness.

The embodiments provide a modified siloxane polymer composition that exhibits increased crack resistance (to thereby secure stability of a light emitting element) and decreased tackiness (to thereby improve workability as well as maintaining high heat resistance and light resistance.

## Claims

1. A modified siloxane polymer composition comprising a modified siloxane polymer and a reticular siloxane polymer,
the modified siloxane polymer including:
a cyclic siloxane moiety having at least two Si-O bonds with a cyclic structure,
a substituted or unsubstituted linear siloxane moiety linked to Si of the cyclic siloxane moiety with a C2 to C10 alkylene group therebetween, and double bonds at its terminal ends
wherein the reticular siloxane polymer is represented by the following Chemical Formula 3:
[Chemical Formula 3] [R¹³SiO_{3/2}]_{T} [R¹⁴R¹⁵SiO]_{D} [R¹⁶R¹⁷R¹⁸SiO_{1/2}]_{M}
wherein in Chemical Formula 3, R¹³ to R¹⁸ are each independently a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, a Halogen, or a combination thereof, provided that at least one of R¹⁶, R¹⁷ and R¹⁸ is an alkenyl group, T>0, D≥0, M>0, and T+D+M=1.

2. The modified siloxane polymer composition as claimed in claim 1, the modified siloxane polymer is obtained by a reaction of a compound represented by the following Chemical Formula 1 and a compound represented by the following Chemical Formula 2: 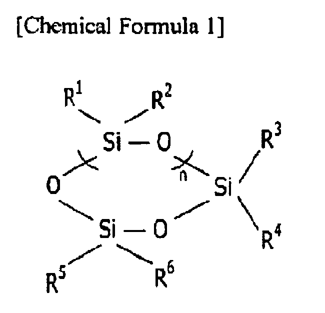 wherein, in the Chemical Formula 1, R¹ to R⁶ are each independently a hydrogen atom, a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, halogen, or a combination thereof, at least two of R¹ to R⁶ are hydrogen, and n is an integer of 0 to 10, 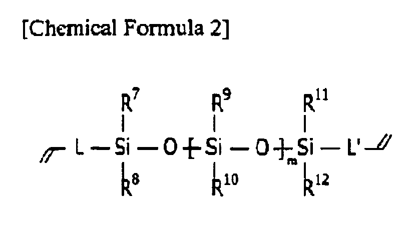 wherein, in the Chemical Formula 2, L and L' are each independently a single bond, a C1 to C8 alkylene group, R⁷ to R¹² are each independently a substituted or unsubstituted C1 to C10 alkyl group, a substituted or unsubstituted C3 to C20 cycloalkyl group, a substituted or unsubstituted C6 to C20 aryl group, a substituted or unsubstituted C7 to C20 arylalkyl group, a substituted or unsubstituted C1 to C20 heteroalkyl group, a substituted or unsubstituted C2 to C20 heterocycloalkyl group, a substituted or unsubstituted C2 to C20 alkenyl group, a substituted or unsubstituted C2 to C20 alkynyl group, a substituted or unsubstituted C1 to C10 alkoxy group, halogen, or a combination thereof, and m is an integer of 0 to 500.

3. The modified siloxane polymer composition as claimed in claim 2, wherein L and L' of the compound represented by the Chemical Formula 2 are each independently selected from a single bond, a methylene group, an ethylene group, a propylene group, a butylene group, and a pentylene group.

4. The modified siloxane polymer composition as claimed in any one of claims 1 to 3, wherein the cyclic siloxane moiety is included at an average of one or more per a molecule of the modified siloxane polymer.

5. The modified siloxane polymer composition as claimed any one of claims 1 to 4, wherein the modified siloxane polymer has a number average molecular weight of≥500 Da to ≤30000 Da.

6. The modified siloxane polymer composition as claimed any one of claims 1 to 5, wherein the modified siloxane polymer is included in an amount of ≥ 5 to ≤ 95 wt%, based on a total weight of the modified siloxane polymer composition.

7. The modified siloxane polymer composition as claimed any one of claims 1 to 6, further comprising a curing agent including at least two silicon-hydrogen bonds.

8. The modified siloxane polymer composition as claimed any one of claims I to 7, further comprising a hydrosilylation reaction catalyst.

9. An encapsulant obtained by curing the modified siloxane polymer pomposition as claimed any one of claims 1 to 8.

10. An electronic device comprising the encapsulant as claimed in claim 9.

11. The electronic device as claimed in claim 10, wherein the electronic device includes a light emitting diode, an organic light emitting device, photo luminance device, or a solar cell encapsulated by the encapsulant.

## Patentansprüche

1. Eine modifizierte Siloxanpolymerzusammensetzung umfassend ein modifiziertes Siloxanpolymer und ein vernetztes Siloxanpolymer,
wobei das modifizierte Siloxanpolymer
einen zyklischen Siloxanrest mit mindestens zwei Si-O-Bindungen mit einer zyklischen Struktur, einen substituierten oder unsubstituierten linearen Siloxanrest gebunden an das Si des zyklischen Siloxanrests mit einer C2- bis C10-Alkylengruppe dazwischen, und Doppelbindungen an seinen terminalen Enden beinhaltet,
wobei das vernetzte Siloxanpolymer durch die folgende chemische Formel 3 dargestellt ist:
[**Chemische Formel 3**] [R¹³SiO_{3/2}]_{T}[R¹⁴R¹⁵SiO]_{D}[R¹⁶R¹⁷R¹⁸SiO_{1/2}]_{N}
wobei in der chemischen Formel 3 R" bis R¹⁸ jeweils unabhängig voneinander eine substituierte oder unsubstituierte C1- bis C10-Alkylgruppe, eine substituierte oder unsubstituierte C3- bis C20-Cycloalkylgruppe, eine substituierte oder unsubstituierte C6-bis C20-Arylgruppe, eine substituierte oder unsubstituierte C7- bis C20-Arylalkylgruppe, eine substituierte oder unsubstituierte C1- bis C20-Heteroalkylgruppe, eine substituierte oder unsubstituierte C2- bis C20-Heterocycloalkylgruppe, eine substituierte oder unsubstituierte C2- bis C20-Alkenylgruppe, eine substituierte oder unsubstituierte C2- bis C20-Alkynylgruppe, eine substituierte oder unsubstituierte C1- bis C10-Alkoxygruppe, ein Halogen oder deren Kombination darstellen mit der Maßgabe, dass zumindest einer der Reste R¹⁶, R¹⁷ und R¹⁸ eine Alkenylgruppe darstellt, T>0, D≥0, M>0 und T+D+M=1.

2. Die modifizierte Siloxanpolymerzusammensetzung nach Anspruch 1, wobei das modifizierte Siloxanpolymer durch eine Reaktion einer Verbindung dargestellt durch die folgende chemische Formel 1 und einer Verbindung dargestellt durch die folgende chemische Formel 2 erhalten wird: 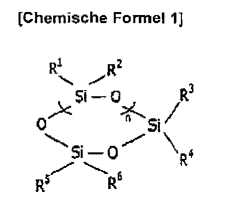 wobei in der chemischen Formel 1 R¹ bis R⁶ jeweils unabhängig voneinander ein Wasserstoffatom, eine substituierte oder unsubstituierte C1- bis C10-Alkylgruppe, eine substituierte oder unsubstituierte C3- bis C20-Cycloalkylgruppe, eine substituierte oder unsubstituierte C6- bis C20-Arylgruppe, eine substituierte oder unsubstituierte C7- bis C20-Arylalkylgruppe, eine substituierte oder unsubstituierte C1- bis C20-Heteroalkylgruppe, eine substituierte oder unsubstituierte C2- bis C20-Heterocycloalkylgruppe, eine substituierte oder unsubstituierte C2- bis C20-Alkenylgruppe, eine substituierte oder unsubstituierte C2- bis C20-Alkinylgruppe, eine substituierte oder unsubstituierte C1- bis C10-Alkoxygruppe, Halogen oder deren Kombination darstellen, mindestens zwei der Reste R¹ bis R⁶ Wasserstoff sind und n eine ganze Zahl von 0 bis 10 ist, 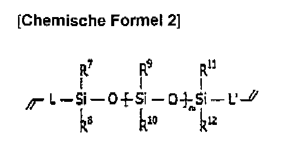 wobei in der chemischen Formel 2 L und L' jeweils unabhängig voneinander eine Einfachbindung oder eine C1- bis C8-Alkylengruppe darstellen, R⁷ bis R¹² jeweils unabhängig voneinander jeweils eine substituierte oder unsubstituierte C1- bis C10-Alkylgruppe, eine substituierte oder unsubstituierte C3- bis C20-Cycloalkylgruppe, eine substituierte oder unsubstituierte C6- bis C20-Arylgruppe, eine substituierte oder unsubstituierte C7- bis C20-Arylalkylgruppe, eine substituierte oder unsubstituierte C1-bis C20-Heteroalkylgruppe, eine substituierte oder unsubstituierte C2- bis C20-Heterocycloalkylgruppe, eine substituierte oder unsubstituierte C2- bis C20-Alkenylgruppe, eine substituierte oder unsubstituierte C2- bis C20-Alkinylgruppe, eine substituierte oder unsubstituierte C1- bis C10-Alkoxygruppe, Halogen oder deren Kombination darstellen und m eine ganze Zahl von 0 bis 500 ist.

3. Die modifizierte Siloxanpolymerzusammensetzung nach Anspruch 2, wobei L und L' der durch die chemische Formel 2 dargestellte Verbindung jeweils unabhängig voneinander aus einer Einfachbindung, einer Methylengruppe, einer Ethylengruppe, einer Propylengruppe, einer Butylengruppe und einer Pentylengruppe ausgewählt sind.

4. Die modifizierte Siloxanpolymerzusammensetzung nach einem der Ansprüche 1 bis 3, wobei durchschnittlich ein oder mehr zyklische Siloxanreste pro Molekül des modifizierten Siloxanpolymers enthalten sind.

5. Die modifizierte Siloxanpolymerzusammensetzung nach einem der Ansprüche 1 bis 4, wobei das modifizierte Siloxanpolymer ein zahlenmittleres Molekulargewicht von ≥500 Da bis ≤30000 Da aufweist.

6. Die modifizierte Siloxanpolymerzusammensetzung nach einem der Ansprüche 1 bis 5, wobei das modifizierte Siloxanpolymer in einer Menge von ≥ 5 bis ≤ 95 Gew.-% basierend auf dem Gesamtgewicht der modifizierten Siloxanpolymerzusammensetzung enthalten ist.

7. Die modifizierte Siloxanpolymerzusammensetzung nach einem der Ansprüche 1 bis 6, zusätzlich umfassend ein Vernetzungsmittel mit mindestens zwei Silikon-Wasserstoff-Bindungen.

8. Die modifizierte Siloxanpolymerzusammensetzung nach einem der Ansprüche 1 bis 7, zusätzlich umfassend einen Hydrosilylierungskatalysator.

9. Ein Verkapselungsmaterial erhalten durch Vernetzung der modifizierten Siloxanpolymerzusammensetzung nach einem der Ansprüche 1 bis 8.

10. Eine elektronische Vorrichtung umfassend das Verkapselungsmaterial nach Anspruch 9.

11. Die elektronische Vorrichtung nach Anspruch 10, wobei die elektronische Vorrichtung eine Licht emittierende Diode, eine organische Licht emittierende Vorrichtung, eine Photoluminiszenzvorrichtung oder eine durch das Verkapselungsmaterial eingekapselte Solarzelle beinhaltet.

## Revendications

1. Composition de polymère de siloxane modifié comprenant un polymère de siloxane modifié et un polymère de siloxane réticulaire,
le polymère de siloxane modifié incluant :
une fraction de siloxane cyclique ayant au moins deux liaisons Si-O avec une structure cyclique,
une fraction de siloxane linéaire substitué ou non substitué liée au Si de la fraction de siloxane cyclique avec un groupe alkylène C2 à C10 entre eux, et
des liaisons doubles au niveau de ses extrémités terminales
dans laquelle le polymère de siloxane réticulaire est représenté par la Formule Chimique 3 suivante :
[Formule Chimique 3] [R¹³SiO_{3/2}]_{T}[R¹⁴R¹⁵SiO]_{D}[R¹⁶R¹⁷R¹⁸SiO_{1/2}]_{M}
dans laquelle, dans la Formule Chimique 3, R¹³ à R¹⁸ sont chacun indépendamment un groupe alkyle C1 à C10 substitué ou non substitué, un groupe cycloalkyle C3 à C20 substitué ou non substitué, un groupe aryle C6 à C20 substitué ou non substitué, un groupe arylalkyle C7 à C20 substitué ou non substitué, un groupe hétéroalkyle C1 à C20 substitué ou non substitué, un groupe hétérocycloalkyle C2 à C20 substitué ou non substitué, un groupe alcényle C2 à C20 substitué ou non substitué, un groupe alcynyle C2 à C20 substitué ou non substitué, un groupe alcoxy C1 à C10 substitué ou non substitué, un halogène, ou une combinaison de ceux-ci, à condition qu'au moins un de R¹⁶, R¹⁷ et R¹⁸ soit un groupe alcényle, T > 0, D ≥ 0, M > 0 et T+D+M = 1.

2. Composition de polymère de siloxane modifié selon la revendication 1, le polymère de siloxane modifié est obtenu par une réaction d'un composé représenté par la Formule Chimique 1 suivante et d'un composé représenté par la Formule Chimique 2 suivante : 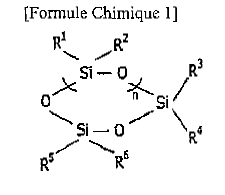 dans laquelle, dans la Formule Chimique 1, R¹ à R⁶ sont chacun indépendamment un atome d'hydrogène, un groupe alkyle C1 à C10 substitué ou non substitué, un groupe cycloalkyl C3 à C20 substitué ou non substitué, un groupe aryle C6 à C20 substitué ou non substitué, un groupe arylalkyle C7 à C20 substitué ou non substitué, un groupe hétéroalkyle C1 à C20 substitué ou non substitué, un groupe hétérocycloalkyle C2 à C20 substitué ou non substitué, un groupe alcényle C2 à C20 substitué ou non substitué, un groupe alcynyle C2 à C20 substitué ou non substitué, un groupe alcoxy C1 à C10 substitué ou non substitué, un halogène, ou une combinaison de ceux-ci, au moins deux de R¹ à R⁶ sont de l'hydrogène, et n est un entier de 0 à 10, 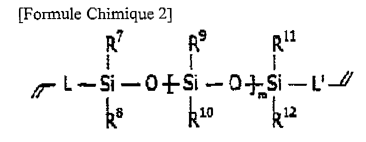 dans laquelle, dans la Formule Chimique 2, L et L' sont chacun indépendamment une liaison simple, un groupe alkylène C1 à C8, R⁷ à R¹² sont chacun indépendamment un groupe alkyle C1 à C10 substitué ou non substitué, un groupe cycloalkyle C3 à C20 substitué ou non substitué, un groupe aryle C6 à C20 substitué ou non substitué, un groupe arylalkyle C7 à C20 substitué ou non substitué, un groupe hétéroalkyle C1 à C20 substitué ou non substitué, un groupe hétérocycloalkyle C2 à C20 substitué ou non substitué, un groupe alcényle C2 à C20 substitué ou non substitué, un groupe alcynyle C2 à C20 substitué ou non substitué, un groupe alcoxy C1 à C10 substitué ou non substitué, un halogène, ou une combinaison de ceux-ci, et m est un entier de 0 à 500.

3. Composition de polymère de siloxane modifié selon la revendication 2, dans laquelle L et L' du composé représenté par la Formule Chimique 2 sont chacun indépendamment sélectionnés à partir d'une liaison simple, d'un groupe méthylène, d'un groupe éthylène, d'un groupe propylène, d'un groupe butylène et d'un groupe pentylène.

4. Composition de polymère de siloxane modifié selon l'une quelconque des revendications 1 à 3, dans laquelle la fraction de siloxane cyclique est incluse à une moyenne d'une ou plus par molécule du polymère de siloxane modifié.

5. Composition de polymère de siloxane modifié selon l'une quelconque des revendications 1 à 4, dans laquelle le polymère de siloxane modifié a une masse moléculaire moyenne en nombre ≥ 500 Da à ≤ 30 000 Da.

6. Composition de polymère de siloxane modifié selon l'une quelconque des revendications 1 à 5, dans laquelle le polymère de siloxane modifié est inclus en une quantité ≥ 5 à ≤ 95 % en poids, sur la base d'un poids total de la composition de polymère de siloxane modifié.

7. Composition de polymère de siloxane modifié selon l'une quelconque des revendications 1 à 6, comprenant en outre un agent de réticulation incluant au moins deux liaisons silicium-hydrogène.

8. Composition de polymère de siloxane modifié selon l'une quelconque des revendications 1 à 7, comprenant en outre un catalyseur de réaction d'hydrosilylation.

9. Matière d'enrobage obtenue en réticulant la composition de polymère de siloxane modifié selon l'une quelconque des revendications 1 à 8.

10. Dispositif électronique comprenant la matière d'enrobage selon la revendication 9.

11. Dispositif électronique selon la revendication 10, dans lequel le dispositif électronique inclut une diode électroluminescente, un dispositif émettant de la lumière organique, un dispositif de photoluminance, ou une cellule solaire encapsulée par la matière d'enrobage.
